(19) Europäisches Patentamt
European Patent Office
Office européen des brevets

(11) **EP 2 704 330 A1**

(12) **EUROPEAN PATENT APPLICATION**
published in accordance with Art. 153(4) EPC

(43) Date of publication:
05.03.2014 Bulletin 2014/10

(51) Int Cl.:
*H03M 13/27* (2006.01)

(21) Application number: 12776607.9

(86) International application number:
PCT/CN2012/073593

(22) Date of filing: 06.04.2012

(87) International publication number:
WO 2012/146124 (01.11.2012 Gazette 2012/44)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 26.04.2011 CN 201110105086

(71) Applicant: ZTE Corporation
Shenzhen, Guangdong 518057 (CN)

(72) Inventor: DU, Jinzhou
Shenzhen
Guangdong 518057 (CN)

(74) Representative: Fassio, Valeria et al
Jacobacci & Partners S.p.A.
Corso Emilia, 8
10152 Torino (IT)

(54) **TURBO DECODING METHOD AND DEVICE**

(57)     Provided are a TURBO decoding method and device. In each iteration procedure when performing multipath parallel decoding on code blocks to be decoded, the method includes: for the code blocks to be decoded in a current path, the decoding module obtaining all first intermediate variables of the current path by means of recurrence from front to back, and at the same time, obtaining all second intermediate variables of the current path by means of recurrence from back to front; the decoding module obtaining all LLRs of the current path according to all the obtained first intermediate variables and second intermediate variables and all branch transferring metrics of the code blocks to be decoded; the decoding module obtaining prior information and a decoding result outputted by the current path according to all the logarithmic likelihood ratios. By means of the present invention, in each parallel path of decoding modules, the method whereby two kinds of intermediate variables are simultaneously calculated by forward recurrence and recurrence from back to front respectively is applied, solving the problem in existing parallel decoding method that the time of each iteration is too long, thus greatly shortening decoding delay, and improving decoding speed.

For the code blocks to be decoded in the current path, a decoding module obtains all the first intermediate variables of the current path by means of recurrence from front to back, and at the same time, obtains all the second intermediate variables of the current path by means of recurrence from back to front — S302

The decoding module obtains all the logarithmic likelihood ratios of the current path according to all the obtained first intermediate variables and second intermediate variables and all branch transition metrics of the code blocks to be decoded — S304

The decoding module obtains the prior information and decoding result output by the current path according to all the logarithmic likelihood ratios — S306

**Fig. 3**

## Description

### Technical Field

The present invention relates to the field of communications, and in particular, to a TURBO decoding method and device.

### Background

TURBO code has been widely applied in wireless communication systems since being proposed in 1993 due to its excellent performance of being approximate to Shannon limit, and has been determined as one of the channel coding/decoding schemes of the Third Generation Partnership Project (3GPP in short) mobile communication system. In the Long Term Evolution (LTE in short) system, higher transmission rate and better code error performance are required, and thus the requirements to channel coding/decoding are improved correspondingly. However, due to the iteration property of the Turbo decoding algorithm, it may be problematic when being implemented in hardware, in which the most important is decoding speed. Therefore, reducing decoding complexity and decoding delay becomes an important problem during hardware implementation, and the compromise consideration on performance and resource are the key to implement the Turbo code.

In the related art, turbo decoding usually employs log-MAP or MAX-log-MAP algorithm. The important features of this algorithm are that it requires to perform iterations many times continuously during hardware implementation, and it also requires to perform recurrence iteration on intermediate variables alpha and beta during each iteration. These features enlarges the system delay of turbo decoding, which is disadvantageous for the application of the turbo decoding in high-speed 3G and LTE systems. Regarding this problem, a solution currently proposed in the related art is to employ a multipath parallel decoding method, in which method, received data are divided into a plurality of blocks according to the code restraint length and the actual length of the input data, the received data are decoded simultaneously and are sent to corresponding error factor controllers after one decoding is completed to calculate the error factors thereof. In this method, during the processing of each parallel decoding module, intermediate variables (alpha and beta) are calculated respectively, and therefore, the decoding time is relatively long.

Another solution employed in the related art is a turbo decoding method based on sliding window control, and the purpose of performing control based on a sliding window is to save the storage space of intermediate variables (alpha and beta), but the problem of hardware implementation caused during the recurrence of intermediate variables is not solved.

### Summary

The present invention provides a turbo decoding method and device, which can at least solve the problem in the related art that the decoding delay is too long and the decoding speed is not high due to the fact that the intermediate variables are recurred and calculated respectively.

According to one aspect of the present invention, a turbo decoding method is provided, in each iteration procedure when performing multipath parallel decoding on code blocks to be decoded, when a decoding module of each path performs decoding, the method includes: for the code blocks to be decoded in a current path, the decoding module obtaining all first intermediate variables of the current path by means of recurrence from front to back, and at the same time, obtaining all second intermediate variables of the current path by means of recurrence from back to front; the decoding module obtaining all logarithmic likelihood ratios of the current path according to all the obtained first intermediate variables and second intermediate variables and all branch transition metrics of the code blocks to be decoded; and the decoding module obtaining prior information and a decoding result output by the current path according to all the logarithmic likelihood ratios.

Preferably, the decoding module obtaining all the first intermediate variables of the current path by means of recurrence from front to back, and at the same time, obtaining all the second intermediate variables of the current path by means of recurrence from back to front includes: the decoding module obtaining all the branch transition metrics of the current path by means of recurrence from front to back, and obtaining all the first intermediate variables of the current path by means of recurrence from front to back according to all the obtained branch transition metrics; and at the same time, the decoding module obtaining all the branch transition metrics of the current path by means of recurrence from back to front, and obtaining all the second intermediate variables of the current path by means of recurrence from back to front according to all the branch transition metrics obtained this time.

Preferably, the decoding module obtaining all the first intermediate variables of the current path by means of recurrence from front to back according to all the obtained branch transition metrics includes: when recurring the first one, counting from front to back, of the first intermediate variables of a front half of the code blocks to be decoded of the current path, after performing an ADD operation, while performing a normalization operation, the decoding module performing an ADD operation of recurring the first one, counting from front to back, of the first intermediate variables of a back half of the code blocks to be decoded; and the decoding module performing an ADD operation of recurring the second one, counting from front to back, of the first intermediate variables of the front half and at the same time performing a normalization operation of the first one, counting from front to back, of the first intermediate variables of the back half, then performing an ADD operation of the second one, counting from front to back, of the first intermediate variables of the back half while performing a normalization operation of the second one, counting from front to back, of the first intermediate variables of the front half, and so on, to obtain all the first intermediate variables of the current path by means of recurrence.

Preferably, the decoding module obtaining all the second intermediate variables of the current path by means of recurrence from back to front according to all the obtained branch transition metrics includes: when recurring the first one, counting from back to front, of the second intermediate variables of a back half of the code blocks to be decoded of the current path, after performing an ADD operation, while performing a normalization operation, the decoding module performing an ADD operation of recurring the first one, counting from back to front, of the second intermediate variables of a front half of the current path of code blocks to be decoded; and the decoding module performing an ADD operation of recurring the second one, counting from back to front, of the second intermediate variables of the back half and at the same time performing a normalization operation of the first one, counting from back to front, of the second intermediate variables of the front half, and performing an ADD operation of the second one, counting from back to front, of the second intermediate variables of the front half while performing a normalization operation of the second one, counting from back to front, of the second intermediate variables of the back half, and so on, to obtain all the second intermediate variables of the current path by means of recurrence.

Preferably, the method further includes: the decoding module storing the first intermediate variables corresponding to a front half of code blocks of the front half and the first intermediate variables corresponding to a front half of code blocks of the back half in a storage; and the decoding module storing the second intermediate variables corresponding to a back half of code blocks of the back half and the second intermediate variables corresponding to a back half of code blocks of the front half in the storage.

Preferably, the decoding module obtaining all the logarithmic likelihood ratios of the current path according to all the obtained first intermediate variables and second intermediate variables and all the branch transition metrics of the code blocks to be decoded includes: when recurring the first intermediate variables corresponding to the back half of code blocks of the front half and the first intermediate variables corresponding to the back half of code blocks of the back half, each time obtaining one of the first intermediate variables by means of recurrence, the decoding module reading the stored second intermediate variable corresponding to this location, and obtaining one logarithmic likelihood ratio corresponding to this location according to the first intermediate variable, the second intermediate variable and the branch transition metric corresponding to this location; and when recurring the second intermediate variables corresponding to the front half of code blocks of the back half and the second intermediate variables corresponding to the front half of code blocks of the front half, each time obtaining one of the second intermediate variables by means of recurrence, the decoding module reading the stored first intermediate variable corresponding to this location, and obtaining one logarithmic likelihood ratio corresponding to this location according to the second intermediate variable, the first intermediate variable and the branch transition metric corresponding to this location.

Preferably, after obtaining the decoding result of each path, the method further includes: performing cyclic redundancy check (CRC) according to the decoding result of each path and a CRC code of the code blocks to be decoded, if the check passes, then stopping iteration and completing the decoding process, otherwise, performing the next iteration process using the prior information output by each path.

According to another aspect of the present invention, a TURBO device is provided, including: decoding modules of multiple paths, wherein a decoding module of each path includes: a recurrence module configured to, for code blocks to be decoded in a current path, obtain all first intermediate variables of the current path by means of recurrence from front to back, and at the same time, obtain all second intermediate variables of the current path by means of recurrence from back to front; a logarithmic likelihood ratio (LLR) calculation module configured to obtain all LLRs of the current path according to all the obtained first intermediate variables and second intermediate variables and all branch transition metrics of the code blocks to be decoded; and a hard decision module configured to perform hard decision on all the LLRs obtained by the LLR calculation module and output a hard decision result as a decoding result.

Preferably, the recurrence module includes: a first branch transition metric calculation module configured to obtain all the branch transition metrics of the current path by means of recurrence from front to back; a first intermediate variable calculation module configured to obtain all the first intermediate variables of the current path by means of recurrence from front to back according to the all the branch transition metrics obtained by the first branch transition metric calculation module; a second branch transition metric calculation module configured to obtain all the branch transition metrics of the current path by means of recurrence from back to front; and a second intermediate variable calculation module configured to obtain all the second intermediate variables of the current path by means of recurrence from back to front according to the all the branch transition metrics obtained by the second branch transition metric calculation module.

Preferably, the first intermediate variable calculation module includes: a first ADD operation unit and a first normalization operation unit, wherein the first ADD operation unit is configured to perform an ADD operation in the process of recurring each of the first intermediate variables; and the first normalization operation unit is configured to perform a normalization operation in the process of recurring each of the first intermediate variables.

Preferably, the second intermediate variable calculation module includes: a second ADD operation unit and a second normalization operation unit, wherein the second ADD operation unit is configured to perform an ADD operation in the process of recurring each of the second intermediate variables; and the second normalization operation unit is configured to perform a normalization operation in the process of recurring each of the second intermediate variables.

Preferably, the decoding module further includes: a storage module configured to store the first intermediate variables corresponding to a front half of code blocks of a front half and the first intermediate variables corresponding to a first half of code blocks of a back half, and the second intermediate variables corresponding to a back half of code blocks of a back half and the second intermediate variables corresponding to a back half of code blocks of a front half.

Preferably, the device further includes: an output control module configured to perform cyclic redundancy check (CRC) according to the decoding result of each path and a CRC code of the code blocks to be decoded, if the check passes, then stop iteration and complete the decoding process, otherwise, perform the next iteration process using prior information output by each path.

By means of the present invention, in each parallel path of decoding modules, two intermediate variables are simultaneously calculated by recurrence from front to back and recurrence from back to front respectively, solving the problem in existing parallel decoding method that the time of each iteration is too long, thus greatly shortening decoding delay, and improving decoding speed.

**Brief Description of the Drawings**

Drawings, provided for further understanding of the present invention and forming a part of the specification, are used to explain the present invention together with embodiments of the present invention rather than to limit the present invention. In the drawings:

Fig. 1 is a basic schematic diagram of turbo decoding;

Fig. 2 is a schematic diagram of the hardware architecture of a turbo decoding device;

Fig. 3 is a flowchart of a turbo decoding method according to an embodiment of the present invention;

Fig. 4 is a schematic diagram of multipath parallel decoding according to an embodiment of the present invention;

Fig. 5 is a schematic diagram of the processing flow of the second path in multiple parallel paths according to an embodiment of the present invention;

Fig. 6 is a structural schematic diagram of a decoding module in a turbo decoding device according to an embodiment of the present invention;

Fig. 7 is a structural schematic diagram of a recurrence module according to a preferred embodiment of the present invention;

Fig. 8 is a structural schematic diagram of a recurrence module according to another preferred embodiment of the present invention; and

Fig. 9 is a schematic diagram of the hardware structure of a decoding module according to a preferred embodiment of the present invention.

**Detailed Description of the Embodiments**

The present invention is described below with reference to the accompanying drawings and embodiments in detail. Note that, the embodiments of the present invention and the features of the embodiments can be combined with each other if there is no conflict.

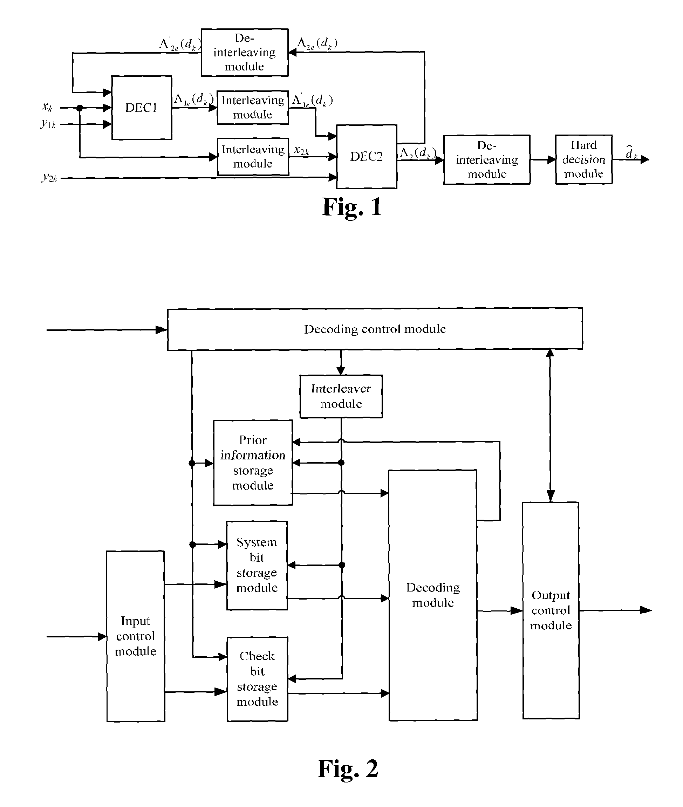

Fig. 1 is basic schematic diagram of turbo decoding, and as shown in Fig. 1, prior information ($x_k$) and check bit 1 ($y_{1k}$) are input into a decoding module 1 (DEC1). For a decoding method employing long-MAP or MAX-long-MAP algorithm, MAP1 calculation is performed on the input code blocks to be decoded in DEC1, and then the result is input into an interleaving module for interleaving, and then input into a decoding module 2 (DEC2), MAP2 calculation is performed on the interleaved result and an input check bit 2 ($y_{2k}$), and the result is output by a de-interleaving module or input into the decoding module 1 as prior information.

Fig. 2 is a schematic diagram of the hardware architecture of a turbo decoding device, and as shown in Fig. 2, the device mainly includes: an input control module, a system bit/check bit/prior information module, an interleaving module, a decoding module (DEC), a decoding control module and an output control module.

The input control module is mainly responsible for distinguishing the data input by a turbo decoder according to system bit, check bit 1, check bit 2 data, system tail bit, interleaved system tail bit, check 1 tail bit and check 2 tail bit, and at the same time generating a related chip selection control signal and controlling the write operation of system bit RAM and check bit RAM.

The system bit/check bit/prior information module completes the read/write operation of system bit, check bit and prior information respectively. The data to be decoded from the input control module are written into the corresponding RAMs according to decoding parallel degree. After decoding is activated, data are read from the respective RAMs according to the sequence/interleaving address and sent to the decoding module for decoding.

The interleaving module provides the interleaving address in real time, so that the turbo decoder can obtain interleaved system bit and prior information when calculating MAP2, thus calculating the current prior information and writing the prior information into the prior information storage RAM.

The decoding module mainly performs decoding according to the data output by the system bit/check bit/prior information module, writes the prior information data obtained by calculation back into the prior information storage RAM, and sends the decoding result to the output control module.

The decoding control module controls the operation of the entire turbo decoding core and is responsible for generating decoding activation signals, code block related parameters, data read/write enable, address, ping-pong control signals and calculation enable signals and so on.

The output control module is responsible for the de-interleaving of the decoding result of the code blocks, read/ write control and related parameter output.

Taking a code block with a length of K as an example, the turbo decoding process mainly includes the following steps.

Step 1, the input decoding data (3K + 12 totally) are divided into K system bits, K check bits 1, K check bits 2, 3 system tail bits, 3 interleaved system tail bits, 3 check 1 tail bits, 3 check 2 tail bits after being processed by the input control module, and stored in the corresponding RAMs according to the number of PUs.

Step 2, after the data are written completely, a start signal (start) is pulled up, and multipath parallel decoding starts.

Step 3, MAP1 processing: system bits and check bits 1 are read from the corresponding RAMs according to the original addresses and sent to the parallel MAP processing unit for MAP1 calculation (the MAP1 prior information is zero when calculating the first iteration), and the external information obtained by calculation is written into the prior information RAM. While starting to perform decoding, the interleaver will also be started to calculate the interleaving address and store same, for preparing the interleaving addresses for the subsequent MAP2 processing in advance.

Step 4, MAP2 processing: the check bits 2 read according to the original addresses, system bits and prior information read according to the interleaving addresses (during the first iteration, the tail bit prior information used by MAP2 is zero, and the read/write of the related data corresponding to tail bits does not participate in interleaving) are sent to the parallel MAP processing units for MAP2 calculation, and the prior information obtained by calculation and hard decision result are written into the prior information RAM and the decoding result RAM respectively. By then, one turbo iteration decoding is completed.

Step 5, whether the iteration ending condition is met can be judged according to certain conditions, if yes, then immediately stop iteration decoding, otherwise, return to step 3 until it reaches the preset maximum number of times of iterations.

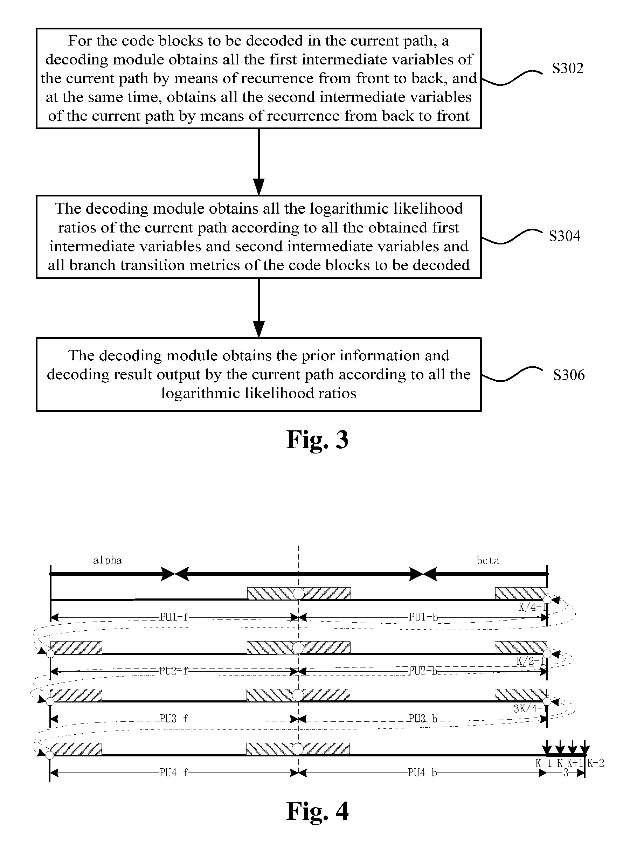

Fig. 3 is a flowchart of a decoding method according to an embodiment of the present invention, and as shown in Fig. 3, during the multipath parallel decoding of code blocks to be decoded, during each iteration, when the decoding module of each path is performing decoding (including MAP1 calculation and MAP2 calculation), the method mainly includes the following steps (step S302 to step S306).

Step S302, for the code blocks to be decoded in the current path, the decoding module obtains all first intermediate variables (that is, alpha) of the current path by means of recurrence from front to back, and at the same time, obtains all second intermediate variables (that is, beta) of the current path by means of recurrence from back to front.

The first intermediate variable can be alpha and the second intermediate variable can be beta, or vice versa, that is, the first intermediate variable is beta and the second intermediate variable is alpha. Preferably, in the embodiments of the present invention, the first intermediate variable is alpha and the second intermediate variable is beta.

In a preferred implementation of the embodiments of the present invention, in order to reduce the space of the storage, the branch transition metrics (that is, gamma) required by recurrence can be calculated for the first intermediate variables and the second intermediate variables respectively. For the first intermediate variables, the decoding module obtains all the branch transition metrics of the current path by means of recurrence from front to back and obtains all the first intermediate variables (alpha) of the current path by means of recurrence from front to back according to the all the obtained branch transition metrics; and at the same time, for the second intermediate variables, the decoding module obtains all the branch transition metrics of the current path by means of recurrence from back to front and obtains all the second intermediate variables (beta) of the current path by means of recurrence from back to front according to all the branch transition metrics obtained this time.

The first intermediate variables and the second intermediate variables are calculated directly employing recurrence formulae, instead of the processing of hardware streamlines. Moreover, each recurrence calculation of the first intermediate variable and the second intermediate variable includes two parts, that is, an ADD operation of adding gamma to the first intermediate variable or the second intermediate variable and a normalization operation, and the delay of the combined circuit logic is also large. Therefore, in a preferred implementation of the embodiments of the present invention, each recurrent calculation of the first intermediate variable or the second intermediate variable is completed with 2 cycles, first an ADD operation is performed, then normalization processing is performed, that is, each recurrence calculation of the first intermediate variable or the second intermediate variable is completed within 2 clocks (clk).

In a preferred implementation of the embodiments of the present invention, time-division calculation is performed for the first intermediate variables and second intermediate variables of the front and back halves of the code blocks to be decoded of the same path. For example, when recurring the first one, counting from front to back, of the first intermediate variables (such as alpha) of the front half of the code blocks to be decoded of the current path, after performing an ADD operation, while performing a normalization operation, the decoding module performs an ADD operation of recurring the first one, counting from front to back, of the first intermediate variables (alpha) of the back half of the code blocks to be decoded of the current path; the decoding module performs an ADD operation of recurring the second one, counting from front to back, of the first intermediate variables (such as alpha) of the front half and at the same time performs a normalization operation of the first one, counting from front to back, of the first intermediate variables (such as alpha) of the back half, then performs an ADD operation of the second one, counting from front to back, of the first intermediate variables (alpha) of the back half while performing a normalization operation of the second one, counting from front to back, of the first intermediate variables (alpha) of the front half, and so on, to obtain all the first intermediate variables (alpha) of the current path by means of recurrence.

Similarly, when recurring the first one, counting from back to front, of the second intermediate variables (such as beta) of the back half of the code blocks to be decoded of the current path, after performing an ADD operation, while performing a normalization operation, the decoding module performs an ADD operation of recurring the first one, counting from back to front, of the second intermediate variables (beta) of the front half of the code blocks to be decoded of the current path; the decoding module performs an ADD operation of recurring the second one, counting from back to front, of the second intermediate variables (beta) of the back half and at the same time performs a normalization operation of the first one, counting from back to front, of the second intermediate variables (beta) of the front half, then performs an ADD operation of the second one, counting from back to front, of the second intermediate variables (beta) of the front half while performing a normalization operation of the second one, counting from back to front, of the second intermediate variables (beta) of the back half, and so on, to obtain all the second intermediate variables (beta) of the current path by means of recurrence.

The first intermediate variables and the second intermediate variables are calculated using the above-mentioned two methods. After calculating the first intermediate variable corresponding to the intermediate bit of the front half, when calculating the first intermediate variables corresponding to the back half of the front half by means of recurrence, the second intermediate variables corresponding to this part have been calculated, therefore, the first intermediate variables calculated for this part do not need to be stored, after obtaining the first intermediate variable, the logarithmic likelihood ratio (LLR) corresponding to this location is calculated directly according to the stored second intermediate variable corresponding to this location and the branch transition metric corresponding to this location. likewise, after calculating the second intermediate variable corresponding to the intermediate bit of the back half, when calculating the second intermediate variables corresponding to the front half of the back half by means of recurrence, the first intermediate variables corresponding to this part have been calculated, therefore, the second intermediate variables calculated for this part do not need to be stored, after obtaining the second intermediate variable, the logarithmic likelihood ratio (LLR) corresponding to this location is calculated directly according to the stored first intermediate variable corresponding to this location and the branch transition metric corresponding to this location. Therefore, in order to save the storage space, in a preferred implementation of the embodiments of the present invention, while performing the above-mentioned operations, the decoding module stores the first intermediate variables (alpha) corresponding to the front half of code blocks of the front half and the first intermediate variables (alpha) corresponding to the front half of code blocks of the back half in a storage; the decoding module stores the second intermediate variables (beta) corresponding to the back half of code blocks of the back half and the second intermediate variables (beta) corresponding to the back half of code blocks of the front half in the storage.

Step S304, the decoding module obtains all the logarithmic likelihood ratios (LLRs) of the current path according to all the obtained first intermediate variables and second intermediate variables and all the branch transition metrics of the code blocks to be decoded.

For example, in this embodiment, when recurring the first intermediate variables (alpha) corresponding to the back half of code blocks of the front half and the first intermediate variables (alpha) corresponding to the back half of code blocks of the back half, each time when obtaining one of the first intermediate variables (alpha) by means of recurrence, the decoding module reads the second intermediate variable (beta) corresponding to this location and obtains logarithmic likelihood ratio corresponding to this location according to the first intermediate variable (alpha), the second intermediate variable (beta) and the branch transition metric (gamma) corresponding to this location; and when recurring the second intermediate variables (beta) corresponding to the front half of code blocks of the back half and the second intermediate variables (beta) corresponding to the front half of code blocks of the front half, each time when obtaining one second intermediate variable (beta) by means of recurrence, the decoding module reads the stored first intermediate variable (alpha) corresponding to this location and obtains a logarithmic likelihood ratio corresponding to this location according to the second intermediate variable (beta), the first intermediate variable (alpha) and the branch transition metric (gamma) corresponding to this location.

For example, the logarithmic likelihood ratio can be calculated according to the following manner:

$$\text{for } k = 1: N$$

$$LIR(k) = \max \left( [alpha(k, 0+1) + gamma\_1(k, 0+1) + beta(k+1, 4+1), \ldots \right.$$

$$alpha(k, 1+1) + gamma\_1(k, 1+1) + beta(k+1, 0+1), \ldots$$

$$alpha(k, 2+1) + gamma\_1(k, 2+1) + beta(k+1, 1+1), \ldots$$

$$alpha(k, 3+1) + gamma\_1(k, 3+1) + beta(k+1, 5+1), \ldots$$

$$alpha(k, 4+1) + gamma\_1(k, 4+1) + beta(k+1, 6+1), \ldots$$

$$alpha(k, 5+1) + gamma\_1(k, 5+1) + beta(k+1, 2+1), \ldots$$

$$alpha(k, 6+1) + gamma\_1(k, 6+1) + beta(k+1, 3+1), \ldots$$

$$alpha(k, 7+1) + gamma\_1(k, 7+1) + beta(k+1, 7+1), \ldots] )$$

$$- \ldots$$

$$\max \left( [alpha(k, 0+1) + gamma\_1(k, 0+1) + beta(k+1, 00+1), \ldots \right.$$

$$alpha(k, 1+1) + gamma\_1(k, 1+1) + beta(k+1, 4+1), \ldots$$

$$alpha(k, 2+1) + gamma\_1(k, 2+1) + beta(k+1, 5+1), \ldots$$

$$alpha(k, 3+1) + gamma\_1(k, 3+1) + beta(k+1, 1+1), \ldots$$

$$alpha(k, 4+1) + gamma\_1(k, 4+1) + beta(k+1, 2+1), \ldots$$

$$alpha(k, 5+1) + gamma\_1(k, 5+1) + beta(k+1, 6+1), \ldots$$

$$alpha(k, 6+1) + gamma\_1(k, 6+1) + beta(k+1, 7+1), \ldots$$

$$alpha(k, 7+1) + gamma\_1(k, 7+1) + beta(k+1, 3+1), \ldots] );$$

$$\text{end}$$

Step S306, the decoding module obtains the prior information and decoding result output by the current path according to all the logarithmic likelihood ratios.

For example, after obtaining the logarithmic likelihood ratios, the priori information currently output can be obtained according to the LLRs currently obtained by calculation and the currently input system bits and prior information.

In this embodiment, after the decoding result of each path is obtained, cyclic redundancy check (CRC) is performed according to the decoding result of each path and the CRC code of the code blocks to be decoded, if the check passes, then iteration will be stopped and the decoding process is completed, otherwise, the next iteration process is performed using the prior information output by each path.

In the relevant art, simultaneous iteration calculation is not performed on the first intermediate variables (alpha) and the second intermediate variables (beta), and thus the problem that the system delay is too long is not solved, besides, when the iteration is performed correctly, the iteration operation cannot be stopped in real time, which further increases the system processing time. While this embodiment employs the method for performing simultaneous iteration calculation on the first intermediate variables (alpha) and the second intermediate variables (beta), which shortens the system delay to half of the original, and at the same time, the decoding result is checked using the CRC check method, and if the check passes, the subsequent repeated iteration process will be stopped in time, saving time costs.

Taking that the first intermediate variable is alpha and the second intermediate variable is beta as an example, the parallel turbo decoding process in the embodiment of the present invention mainly includes the following steps.

Step 1: several PUs (processing units, also referred to as parallel path number, herein, one PU is also one sliding window) are obtained by division according to the length of the code block to prepare for multipath parallel decoding. Each PU is equally divided into two parts, a front part and a back part, which are respectively marked as PU-f (the front half of PU) and PU-b (the back half of PU).

Step 2: the initial values of alpha and beta of PU-f and PU-b (which are marked as alpha0 and beta0, alpha1 and beta1 are obtained by means of the recurrence based on alpha0 and beta0, and alpha2 and beta2 are obtained by means of the recurrence based on alpha1 and beta1 and so on) are set, and the respective overlap (the overlapping window length) is also set. When alpha is iterated from front to back, the PU-f of the first PU has no overlap; and when beta is iterated from back to front, the PU-b of the last PU has no overlap.

Step 3: the gammas of PU-f and PU-b of each PU are calculated using the segmentation method of step 1 and step 2 respectively according to the corresponding system bits, check bits and prior information.

Step 4: alpha is calculated using gamma. It is realized with 2 cycles, that is, alpha + gamma is calculated first, then normalization processing is performed to obtain the next alpha. Here, while performing normalization processing of the nth alpha of PU-f, the alpha + gamma operation of the nth digit of PU-b is performed, which ensures that the throughput rate of decoding is not affected, and at the same time, the values of alphas of the front halves of PU-f and PU-b are stored. The processing flow of beta is similar to alpha, but what are stored are the beta values of the back halves of PU-f and PU-b.

Step 5: when half of PU-f or PU-b is calculated, calculation is performed using the alphas calculated for the back half of PU-f or PU-b and the betas stored for the back half and the corresponding branch transition metrics (gamma) to obtain LLRs (logarithmic likelihood ratios), then the output prior information is calculated according to the LLRs currently obtained by calculation and the currently input system bits and prior information; and at the same time, calculation is performed using the betas calculated for the front half of PU-f or PU-b and the alphas stored for the front half and the corresponding branch transition metrics (gamma) to obtain LLRs, and further obtain the output prior information.

Step 6: after one iteration is completed, a hard decision result is obtained using the LLRs, and CRC check is performed thereon, when the check fails, the next iteration is performed, until it reaches a preset maximum number of times of iterations. When the check passes, the iteration is stopped immediately to prepare for the decoding of the next CB (code block).

With the above-mentioned method provided in the embodiments of the present invention, compared to the existing parallel decoding method, in the case that the total number of cycles (the number of clock periods) does not change during each iteration, the length of the ACS key path when iterating alpha and beta of turbo decoding is greatly shortened (it changes from completing the ADD operation within 1 clk to 2 clks, which is more advantageous for FPGA and ASIC implementation, the frequency and throughput rate of the hardware circuit will be higher); the calculation is performed on alpha from front to back and on beta from back to front simultaneously, so that the decoding delay during each iteration is reduced to 1/2 of the original. When the channel quality is good, the iteration is stopped according to CRC, so that the number of times of iterations during decoding is reduced by multiples (for example, the maximum number of times of iterations is 8, actually, the result is correct with only 1 iteration, and after the iteration being stopped according to CRC is adopted, the decoding time is 1/8 of the original).

Likewise, taking that the length of the code block is K and there are 4 parallel paths, the entire processing flow is as shown in Fig. 4, each path performs decoding in parallel. For each path in particular, the calculation of the overlap part is performed first (dashed arrows), and then the calculation of valid data is performed (solid arrows), as shown in Fig. 4. During MAP1 processing, alpha and beta are calculated simultaneously from two heads of each path respectively. Taking the second path which is relatively typical as an example, the third path is the same as the second path, when alpha is calculated for the front half of the first path, there is no overlap, and when beta is calculated for the back half of the fourth path, the overlap is the tail bit of the entire code block.

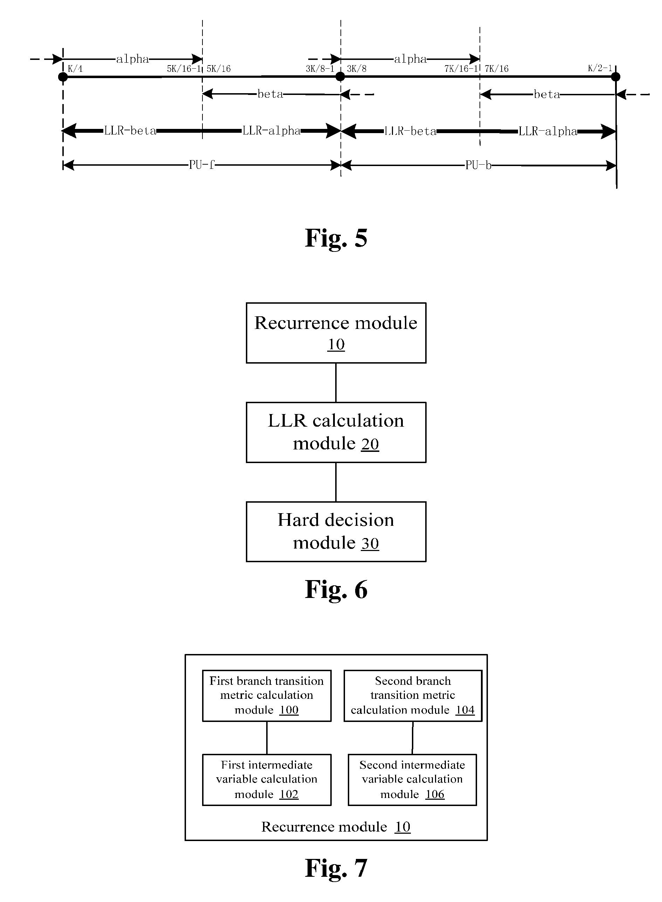

Taking into account the overlapping part (overlap) of each path, it is equivalent to starting from the (K/4-overlap) th and the (3K/8-overlap)th of the code block K respectively temporally, the corresponding system bits, check bits and prior information are read according to the rule of adding 1 successively according to the address, and gamma is calculated according to formula (1). As such, according to the following sequence, gamma(K/4-overlap), gamma(3K/8-overlap), gamma(K/4-overlap+1), gamma(3K/8-overlap+1), ..., gamma(3K/8-1), and gamma(K/2-1) are obtained, and after the gammas are obtained, K/4 corresponding alphas are obtained by gammas according to formula (2), as shown in Fig. 5.

Since the calculation of alpha employs the recurrence formula, it is disadvantageous for the processing method for hardware streamlines. The calculation of alpha each time includes two parts, gamma + alpha and normalization, and the delay of the combined circuit logic is relatively large, which is also disadvantageous for the hardware implementation of FPGA or ASIC. Therefore, in this embodiment, the calculation of alpha is completed with 2 cycles, wherein an ADD operation is performed first, and then normalization processing is performed. Therefore, in this embodiment, time-division calculation is performed on the alpha calculation (which has been completed with 2 cycles) of the front and back halves of the same path. In particular, the ADD operation of alpha(K/4-overlap) is completed within the $1^{st}$ clk; the normalization operation of alpha(K/4-overlap) is completed within the $2^{nd}$ clk (obtaining alpha (K/4-overlap)) and at the same time, the ADD operation of alpha (3K/8-overlap) is completed; the normalization operation of alpha(3K/8-overlap) is completed within the $3^{rd}$ clk (obtaining alpha(3K/8-overlap)) and at the same time, the ADD operation of alpha(K/4-overlap+1) is completed, and so on, after (K/4+overlap) clks, all the alpha values of the current path (including the alpha of the overlap part, there are K/4+overlap totally) are obtained.

The calculation process of beta is similar to alpha, only their directions are opposite. The calculation starts from the (3K/8-1+overlap)th and the (K/2-1+overlap)th of the code block respectively temporally, the corresponding system bits, check bits and prior information are read according to the rule that the address is decreased by 1, gamma is calculated according to formula (1). As such, according to the following sequence, gamma(3K/8-1+overlap), gamma(K/2-1+overlap), gamma(3K/8-2+overlap), gamma(K/2-2+overlap), ..., gamma(K/4) and gamma(3K/8) are obtained, and then the obtained gammas are used, according to a processing method which is similar to alpha calculation, the calculation of beta each time is divided into two cycles to obtain all the beta values of the current path, as shown in Fig. 5.

In this embodiment, the calculation of alpha and beta is performed in the opposite direction, there is no need to store all the alpha and beta values of the current path, instead, only K/8 alpha values and K/8 beta values are stored (alpha and beta can be stored in one RAM with a depth of K/4). The alpha values at K/4 to 5K/16-1 and 3K/8 to 7K/16-1 need to be stored; and the beta values at 3K/8-1 to 5K/16 and K/2-1 to 7K/16 need to be stored. When alpha is calculated to the location 5K/16 and 7K/16 respectively incrementally, beta is calculated to the location 5K/16-1 and 7K/16-1 respectively degressively. At this moment, when 1 alpha and 1 beta are calculated simultaneously, calculation can be performed using the corresponding values read from the storage RAMs of alpha and beta in combination with the branch transition metric (gamma) corresponding to this location to obtain 2 LLRs simultaneously, thus the decoding time can be shorted about 1/2.

After the calculation of LLRs is completed, prior information is obtained corresponding to each LLR calculation. After MAP1 processing, the interleaving of the prior information is realized by sequential writing and interleaved reading the prior information storage RAM. After MAP2 processing, the de-interleaving of the prior information is realized by interleaved writing and sequential reading the prior information storage RAM.

After one iteration is completed (including MAP1 and MAP2), CRC check is performed on the hard decision data after each iteration using the code block segmentation and additional CRC check code of LTE, and if the check passes, then iteration will be stopped. Otherwise, the next iteration will be performed using the new prior information generated after iteration together with the received system bits and check bits.

A turbo decoding device is also provided according to an embodiment of the present invention, which device is used for implementing the above-mentioned method provided in the embodiments of the present invention.

The turbo decoding device according to the embodiments of the present invention improves the turbo decoding device shown in Fig. 2, wherein the decoding module employs multiple paths of parallel decoding modules. Fig. 6 is a structural schematic diagram of each decoding module in the turbo decoding device according to an embodiment of the present invention, and as shown in Fig. 6, the decoding module of each path can include a recurrence module **10,** an LLR calculation module **20** and a hard decision module **30.**

The recurrence module **10** is configured to, for the code blocks to be decoded in the current path, obtain all first intermediate variables (such as alpha) of the current path by means of recurrence from front to back, and at the same time, obtain all the second intermediate variables (such as beta) of the current path by means of recurrence from back to front; the LLR calculation module **20** is connected to the recurrence module **10** and configured to obtain all logarithmic likelihood ratios (LLRs) of the current path according to all the obtained first intermediate variables (alpha) and second intermediate variables (beta) and all branch transition metrics (gamma) of the code blocks to be decoded; and the hard decision module **30** is connected to the LLR calculation module **20** and configured to perform hard decision on all the LLRs obtained by the LLR calculation module and output a hard decision result as the decoding result.

In a preferred implementation of the embodiments of the present invention, as shown in Fig. 7, the recurrence module **10** may include: a first branch transition metric calculation module **100** configured to obtain all the branch transition metrics of the current path by means of recurrence from front to back; a first intermediate variable calculation module **102** configured to obtain all the first intermediate variables (alpha) of the current path by means of recurrence from front to back according to the all the branch transition metrics obtained by the first branch transition metric calculation module **100;** a second branch transition metric calculation module **104** configured to obtain all the branch transition metrics of the current path by means of recurrence from back to front; and a second intermediate variable calculation module **106** configured to obtain all second intermediate variables (beta) of the current path by means of recurrence from front to back according to the all the branch transition metrics obtained by the second branch transition metric calculation module **104.**

The first intermediate variable calculation module **102** may include: a first ADD operation unit and a first normalization operation unit, wherein the first ADD operation unit is configured to perform an ADD operation in the process of recurring each of the first intermediate variables; and the first normalization operation unit is configured to perform a normalization operation in the process of recurring each of the first intermediate variables.

After the first ADD operation unit performs an ADD operation of recurring the first one, counting from front to back, of the first intermediate variables (such as alpha) of the front half of the code blocks to be decoded of the current path, while the first normalization operation unit performs a normalization operation, the first operation unit performs an ADD operation of recurring the first one, counting from front to back, of the first intermediate variables (alpha) of the back half of the code blocks of the current path; then the first operation unit performs an ADD operation of recurring the second one, counting from front to back, of the first intermediate variables (such as alpha) of the front half, and at the same time the first normalization operation unit performs a normalization operation on the first one, counting from front to back, of the first intermediate variables (such as alpha) of the back half, then while the first normalization operation unit performs a normalization of the second one, counting ) from front to back, of the first intermediate variables (alpha of the front half, the first ADD operation unit performs an ADD operation of the second one, counting from front to back, of the first intermediate variables (alpha) of the back half, and so on, to obtain all the first intermediate variables (alpha) of the current path by means of recurrence.

The second intermediate variable calculation module **106** may include: a second ADD operation unit and a second normalization operation unit, wherein the second ADD operation unit is configured to perform an ADD operation in the process of recurring each of the second intermediate variables; and the second normalization operation unit is configured to perform a normalization operation in the process of recurring each of the second intermediate variables.

For example, after the second ADD operation unit performs an ADD operation of recurring the first one, counting from back to front, of the second intermediate variables (such as beta) of the back half of the code blocks to be decoded of the current path, while the second normalization operation unit performs a normalization operation, the second operation unit performs an ADD operation of recurring the first one, counting from back to front, of the second intermediate variables (beta) of the front half of the code blocks of the current path; then the second operation unit performs an ADD operation of recurring the second one, counting from back to front, of the second intermediate variables (beta) of the back half, and at the same time the second normalization operation unit performs a normalization operation on the first one, counting from back to front, of the second intermediate variables (beta) of the front half, then while the second normalization operation unit performs a normalization of the second one, counting from back to front, of the second intermediate variables (beta) of the back half, the second ADD operation unit performs an ADD operation of the second one, counting from back to front, of the second intermediate variables (beta) of the front half, and so on, to obtain all the second intermediate variables (beta) of the current path by means of recurrence.

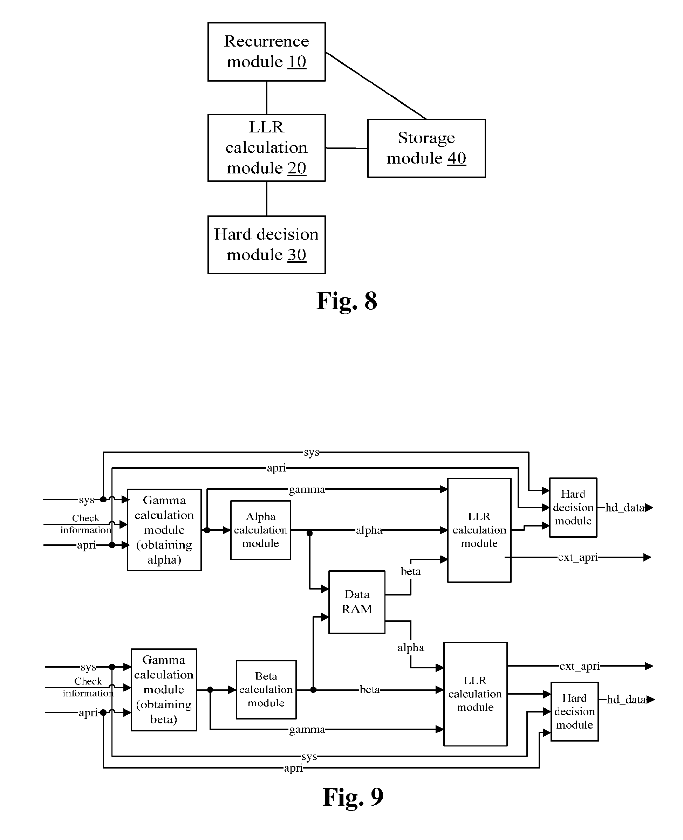

In a preferred implementation of the embodiments of the present invention, as shown in Fig. 8, the decoding module of each path may further include: a storage module **40** configured to store the first intermediate variables obtained by the recurrence module **10** and corresponding to a front half of code blocks of the front half and the first intermediate variables corresponding to a front half of code blocks of the back half, and the second intermediate variables corresponding to a back half of code blocks of the back half and the second intermediate variables corresponding to a back half of code blocks of the front half.

In a preferred implementation of the embodiments of the present invention, the device may also improve the output control module in Fig. 2, the output control module is configured to perform CRC check according to the decoding result output by the decoding module and the cyclic redundancy check code of the code block to be decoded, and if the check passes, then iteration will be stopped and the iteration process is completed, otherwise, the next iteration process is performed using the prior information output by each path of decoding module.

In a preferred implementation of the embodiments of the present invention, two LLR calculation modules **20** corresponding to the first intermediate variable and the second intermediate variable can be set respectively, and two corresponding hard decision modules can also be set. Fig. 9 is a structural schematic diagram of a decoding module **30** according to a preferred embodiment of the present invention, and as shown in Fig. 9, system information (sys), check information (it is check information 1 for MAP1 calculation, and check information 2 for MAP2 calculation) and prior information (apri) are input into a gamma calculation module for alpha (equivalent to the first branch transition metric calculation module) and a gamma calculation module for beta (equivalent to the second branch transition metric calculation module). The first branch transition metric calculation module recurs the LLR from front to back and inputs same into the alpha calculation module (equivalent to the first intermediate variable calculation module), and the alpha calculation module calculates the alphas of this path, a part of which is stored in the data RAM, and a part of which is input into the LLR calculation module, the LLR calculation module calculates the LLR according to the input alpha and the beta stored in the data RAM, outputs prior information (ext_apri), and outputs the LLR obtained by calculation to the hard decision module, and the hard decision module performs an operation according to the input LLR, system information and prior information (apri). Likewise, corresponding processing is performed on beta.

It can be seen from the above description that by means of the technical solution provided in the embodiments of the present invention, about 1/2 decoding delay is shortened by way of simultaneously calculating alpha and beta. Besides, regarding the calculation of the key path alpha and beta of each path, with the improvement on control, the iteration calculation of the key path alpha/beta of the decoding can be done by two stages of streamlines compared from the original one stage of streamlines, without reducing the throughput rate of the decoder, which greatly improves the hardware feasibility and stability of the turbo decoder and also improves the throughput rate. Moreover, in terms of hardware resources, the calculation method of alpha and beta in the opposite direction merely increases the occupation of some register resources but does not increase the occupation of RAM resources, which has little impact on the scale of the entire design circuit.

Obviously, those skilled in the art should know that each of the mentioned modules or steps of the present invention can be realized by universal computing devices; the modules or steps can be focused on single computing device, or distributed on the network formed by multiple computing devices; selectively, they can be realized by the program codes which can be executed by the computing device; thereby, the modules or steps can be stored in the storage device and executed by the computing device; and under some circumstances, the shown or described steps can be executed in different orders, or can be independently manufactured as each integrated circuit module, or multiple modules or steps thereof can be manufactured to be single integrated circuit module, thus to be realized. In this way, the present invention is not restricted to any particular hardware and software combination.

The descriptions above are only the preferable embodiment of the present invention, which are not used to restrict the present invention, for those skilled in the art, the present invention may have various changes and variations. Any amendments, equivalent substitutions, improvements, etc. within the principle of the present invention are all included in the scope of the protection of the present invention.

## Claims

1. A TURBO decoding method, **characterized in that** in each iteration procedure when performing multipath parallel decoding on code blocks to be decoded, when a decoding module of each path performs decoding, the method comprises:

   for the code blocks to be decoded in a current path, the decoding module obtaining all first intermediate variables of the current path by means of recurrence from front to back, and at the same time, obtaining all second intermediate variables of the current path by means of recurrence from back to front;
   the decoding module obtaining all logarithmic likelihood ratios of the current path according to all the obtained first intermediate variables and second intermediate variables and all branch transition metrics of the code blocks to be decoded; and
   the decoding module obtaining prior information and a decoding result output by the current path according to all the logarithmic likelihood ratios.

2. The method according to claim 1, **characterized in that** the decoding module obtaining all the first intermediate variables of the current path by means of recurrence from front to back, and at the same time, obtaining all the second intermediate variables of the current path by means of recurrence from back to front comprises:

   the decoding module obtaining all the branch transition metrics of the current path by means of recurrence from front to back, and obtaining all the first intermediate variables of the current path by means of recurrence from front to back according to all the obtained branch transition metrics; and at the same time,
   the decoding module obtaining all the branch transition metrics of the current path by means of recurrence from back to front, and obtaining all the second intermediate variables of the current path by means of recurrence from back to front according to all the branch transition metrics obtained this time.

3. The method according to claim 2, **characterized in that** the decoding module obtaining all the first intermediate variables of the current path by means of recurrence from front to back according to all the obtained branch transition metrics comprises:

when recurring the first one, counting from front to back, of the first intermediate variables of a front half of the code blocks to be decoded of the current path, after performing an ADD operation, while performing a normalization operation, the decoding module performing an ADD operation of recurring the first one, counting from front to back, of the first intermediate variables of a back half of the code blocks to be decoded; and
the decoding module performing an ADD operation of recurring the second one, counting from front to back, of the first intermediate variables of the front half and at the same time performing a normalization operation of the first one, counting from front to back, of the first intermediate variables of the back half, then performing an ADD operation of the second one, counting from front to back, of the first intermediate variables of the back half while performing a normalization operation of the second one, counting from front to back, of the first intermediate variables of the front half, and so on, to obtain all the first intermediate variables of the current path by means of recurrence.

4. The method according to claim 3, **characterized in that** the decoding module obtaining all the second intermediate variables of the current path by means of recurrence from back to front according to all the obtained branch transition metrics comprises:

when recurring the first one, counting from back to front, of the second intermediate variables of a back half of the code blocks to be decoded of the current path, after performing an ADD operation, while performing a normalization operation, the decoding module performing an ADD operation of recurring the first one, counting from back to front, of the second intermediate variables of a front half of the current path of code blocks to be decoded; and
the decoding module performing an ADD operation of recurring the second one, counting from back to front, of the second intermediate variables of the back half and at the same time performing a normalization operation of the first one, counting from back to front, of the second intermediate variables of the front half, and performing an ADD operation of the second one, counting from back to front, of the second intermediate variables of the front half while performing a normalization operation of the second one, counting from back to front, of the second intermediate variables of the back half, and so on, to obtain all the second intermediate variables of the current path by means of recurrence.

5. The method according to claim 4, **characterized by** further comprising: the decoding module storing the first intermediate variables corresponding to a front half of code blocks of the front half and the first intermediate variables corresponding to a front half of code blocks of the back half in a storage; and the decoding module storing the second intermediate variables corresponding to a back half of code blocks of the back half and the second intermediate variables corresponding to a back half of code blocks of the front half in the storage.

6. The method according to claim 5, **characterized in that** the decoding module obtaining all the logarithmic likelihood ratios of the current path according to all the obtained first intermediate variables and second intermediate variables and all the branch transition metrics of the code blocks to be decoded comprises:

when recurring the first intermediate variables corresponding to the back half of code blocks of the front half and the first intermediate variables corresponding to the back half of code blocks of the back half, each time obtaining one of the first intermediate variables by means of recurrence, the decoding module reading the stored second intermediate variable corresponding to this location, and obtaining one logarithmic likelihood ratio corresponding to this location according to the first intermediate variable, the second intermediate variable and the branch transition metric corresponding to this location; and
when recurring the second intermediate variables corresponding to the front half of code blocks of the back half and the second intermediate variables corresponding to the front half of code blocks of the front half, each time obtaining one of the second intermediate variables by means of recurrence, the decoding module reading the stored first intermediate variable corresponding to this location, and obtaining one logarithmic likelihood ratio corresponding to this location according to the second intermediate variable, the first intermediate variable and the branch transition metric corresponding to this location.

7. The method according to any one of claims 1 to 6, **characterized in that** after obtaining the decoding result of each path, the method further comprises:

performing cyclic redundancy check (CRC) according to the decoding result of each path and a CRC code of the code blocks to be decoded, if the check passes, then stopping iteration and completing the decoding process, otherwise, performing the next iteration process using the prior information output by each path.

8. A TURBO device, **characterized by** comprising: decoding modules of multiple paths, wherein a decoding module of each path comprises:

a recurrence module configured to, for code blocks to be decoded in a current path, obtain all first intermediate variables of the current path by means of recurrence from front to back, and at the same time, obtain all second intermediate variables of the current path by means of recurrence from back to front;
a logarithmic likelihood ratio (LLR) calculation module configured to obtain all LLRs of the current path according to all the obtained first intermediate variables and second intermediate variables and all branch transition metrics of the code blocks to be decoded; and
a hard decision module configured to perform hard decision on all the LLRs obtained by the LLR calculation module and output a hard decision result as a decoding result.

9. The device according to claim 8, **characterized in that** the recurrence module comprises:

a first branch transition metric calculation module configured to obtain all the branch transition metrics of the current path by means of recurrence from front to back;
a first intermediate variable calculation module configured to obtain all the first intermediate variables of the current path by means of recurrence from front to back according to the all the branch transition metrics obtained by the first branch transition metric calculation module;
a second branch transition metric calculation module configured to obtain all the branch transition metrics of the current path by means of recurrence from back to front; and
a second intermediate variable calculation module configured to obtain all the second intermediate variables of the current path by means of recurrence from back to front according to the all the branch transition metrics obtained by the second branch transition metric calculation module.

10. The device according to claim 9, **characterized in that** the first intermediate variable calculation module comprises: a first ADD operation unit and a first normalization operation unit, wherein
the first ADD operation unit is configured to perform an ADD operation in the process of recurring each of the first intermediate variables; and
the first normalization operation unit is configured to perform a normalization operation in the process of recurring each of the first intermediate variables.

11. The device according to claim 9, **characterized in that** the second intermediate variable calculation module comprises: a second ADD operation unit and a second normalization operation unit, wherein
the second ADD operation unit is configured to perform an ADD operation in the process of recurring each of the second intermediate variables; and
the second normalization operation unit is configured to perform a normalization operation in the process of recurring each of the second intermediate variables.

12. The device according to any one of claim 8 to 10, **characterized in that** the decoding module further comprises:

a storage module configured to store the first intermediate variables corresponding to a front half of code blocks of a front half and the first intermediate variables corresponding to a first half of code blocks of a back half, and the second intermediate variables corresponding to a back half of code blocks of a back half and the second intermediate variables corresponding to a back half of code blocks of a front half.

13. The device according to any one of claim 8 to 10, **characterized by** further comprising:

an output control module configured to perform cyclic redundancy check (CRC) according to the decoding result of each path and a CRC code of the code blocks to be decoded, if the check passes, then stop iteration and complete the decoding process, otherwise, perform the next iteration process using prior information output by each path.

**Fig. 1**

**Fig. 2**

For the code blocks to be decoded in the current path, a decoding module obtains all the first intermediate variables of the current path by means of recurrence from front to back, and at the same time, obtains all the second intermediate variables of the current path by means of recurrence from back to front

S302

The decoding module obtains all the logarithmic likelihood ratios of the current path according to all the obtained first intermediate variables and second intermediate variables and all branch transition metrics of the code blocks to be decoded

S304

The decoding module obtains the prior information and decoding result output by the current path according to all the logarithmic likelihood ratios

S306

**Fig. 3**

**Fig. 4**

**Fig. 5**

**Fig. 6**

**Fig. 7**

Recurrence
module 10

LLR
calculation
module 20

Storage
module 40

Hard decision
module 30

## Fig. 8

sys

apri

sys

Check
information

apri

Gamma
calculation
module
(obtaining
alpha)

gamma

Alpha
calculation
module

alpha

LLR
calculation
module

Hard
decision
module

hd_data

ext_apri

beta

Data
RAM

alpha

sys

Check
information

apri

Gamma
calculation
module
(obtaining
beta)

Beta
calculation
module

beta

LLR
calculation
module

ext_apri

gamma

Hard
decision
module

hd_data

sys

apri

## Fig. 9

# INTERNATIONAL SEARCH REPORT

| International application No. |
| --- |
| **PCT/CN2012/073593** |

**A. CLASSIFICATION OF SUBJECT MATTER**

H03M 13/27 (2006.01) i

According to International Patent Classification (IPC) or to both national classification and IPC

**B. FIELDS SEARCHED**

Minimum documentation searched (classification system followed by classification symbols)

IPC: H03M 13/-

Documentation searched other than minimum documentation to the extent that such documents are included in the fields searched

Electronic data base consulted during the international search (name of data base and, where practicable, search terms used)

Data bases: CPRSABS, VEN, CNKI

Key words: TURBO, positive, negative, inversion, parallel, code, recursion, parallel, front, back, forward, backward

**C. DOCUMENTS CONSIDERED TO BE RELEVANT**

| Category* | Citation of document, with indication, where appropriate, of the relevant passages | Relevant to claim No. |
| --- | --- | --- |
| A | CN 101964665 A (SHANGHAI JIAOTONG UNIVERSITY), 02 February 2012 (02.02.2012), claims 1-7, and figure 1 | 1-13 |
| A | WO 2009158341 A2 (FREESCALE SEMICONDUCTOR, INC.), 30 December 2009 (30.12.2009), the whole document | 1-13 |
| PX | CN 102340320 A (UNIVERSITY OF ELECTRONIC SCIENCE AND TECHNOLOGY), 01 February 2012 (01.02.2012), the whole document | 1-7 |

☐ Further documents are listed in the continuation of Box C.     ☒ See patent family annex.

| *   Special categories of cited documents: | "T"   later document published after the international filing date or priority date and not in conflict with the application but cited to understand the principle or theory underlying the invention |
| --- | --- |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
| --- | --- |
| 18 June 2012 (18.06.2012) | **12 July 2012 (12.07.2012)** |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **LIU, Lin** Telephone No.: (86-10) **62412077** |
| --- | --- |

Form PCT/ISA/210 (second sheet) (July 2009)

## INTERNATIONAL SEARCH REPORT
Information on patent family members

| International application No. |
|---|
| **PCT/CN2012/073593** |

| Patent Documents referred in the Report | Publication Date | Patent Family | Publication Date |
|---|---|---|---|
| CN 101964665 A | 02.02.2011 | None | None |
| WO 2009158341 A2 | 30.12.2009 | WO 2009158341 A3 | 06.05.2010 |
| | | US 8171384 B2 | 01.05.2012 |
| CN 102340320 A | 01.02.2012 | None | None |

Form PCT/ISA/210 (patent family annex) (July 2009)